# EUROPÄISCHE PATENTSCHRIFT

(11) **EP 2 472 186 B1**
(45) Veröffentlichungstag und Bekanntmachung des Hinweises auf die Patenterteilung: **16.12.2020**
(21) Anmeldenummer: 11194551.5
(22) Anmeldetag: 20.12.2011
(51) Int. Cl.: G06F 3/0484, F24C 7/08, H03K 17/96

(54) **KOCHFELD**
COOKTOP
PLAQUE DE CUISSON

(30) Priorität: 27.12.2010 ES 201031965
(43) Veröffentlichungstag der Anmeldung: 04.07.2012
(73) Patentinhaber: BSH Hausgeräte GmbH, 81739 München (DE)
(72) Erfinder: Berr, Andreas, 82152 Krailling (DE); Dai, Fang, Nanjing (CN); Mairal Serrano, Carlos Vicente, 50015 Zaragoza (ES)

(56) Entgegenhaltungen:
- EP-A1- 1 691 486
- EP-A1- 1 805 585
- EP-A1- 2 026 178
- EP-A2- 2 065 651
- EP-A2- 2 161 655
- WO-A1-2006/133976
- WO-A1-2009/067224
- WO-A2-2005/106335
- WO-A2-2007/109429
- WO-A2-2009/117795
- DE-A1-102005 004 337
- GB-A- 2 050 621
- US-A1- 2003 028 346
- US-A1- 2010 235 794
- US-B2- 7 830 160

## Beschreibung

Die Erfindung geht aus von einem Kochfeld mit einer Hausgerätevorrichtung nach dem Oberbegriff des Patentanspruchs 1.

Aus der DE 10 2005 027 199 A1 ist eine Hausgerätevorrichtung mit einem berührungsempfindlichen Sensorfeld zum Erfassen einer Berührungsposition auf dem Sensorfeld und mit einer Steuereinheit bekannt, die dazu vorgesehen ist, aus erfassten Berührpositionen auf dem Sensorfeld eine Bewegungskenngröße der Berührung zu bestimmen. Die Steuereinheit ist ferner dazu vorgesehen, in Abhängigkeit von der bestimmten Bewegungskenngröße ein Steuersignal zu erzeugen.

Weiterer Stand der Technik ist in den Dokumenten WO 2006/133976 A1, EP 2 065 651 A2 und US 7 830 160 B2 zu finden.

Die Aufgabe der Erfindung besteht insbesondere darin, eine gattungsgemäße Hausgerätevorrichtung bereitzustellen, welche bei einem gegenüber dem Stand der Technik zumindest gleich bleibenden Bedienkomfort einen vereinfachten Aufbau ermöglicht. Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

Die Erfindung geht aus von einem Kochfeld mit einer Hausgerätevorrichtung mit wenigstens einem berührungsempfindlichen Sensorfeld mit zumindest einem berührungsempfindlichen Sensorelement zu einem Erfassen einer Berührposition auf dem Sensorfeld und mit einer Steuereinheit zum Erzeugen wenigstens eines Steuersignals in Abhängigkeit von der erfassten Berührposition.

Es wird vorgeschlagen, dass das Sensorfeld eine lineare Erstreckung von maximal 70 Millimeter zwischen berührungsempfindlichen Teilen des Sensorfelds zum Erfassen der Berührposition aufweist. Insbesondere soll der Begriff "lineare Erstreckung" keine Einschränkung in Bezug auf eine Anordnung der berührungsempfindlichen Teile des Sensorfelds bedeuten. Grundsätzlich kann die lineare Erstreckung beispielsweise auch von einem Durchmesser gebildet sein. Umfasst das Sensorfeld mehr als ein Sensorelement, kann eine größte lineare Erstreckung zwischen zwei unterschiedlichen Sensorelementen existieren. Dadurch kann bei einer geeigneten Ausgestaltung eine Lösung bereitgestellt werden, die durch eine Verringerung einer Anzahl von Bauelementen vereinfacht und platzsparend ausgeführt werden kann.

Bevorzugt beträgt die lineare Erstreckung zwischen berührungsempfindlichen Teilen des Sensorfelds höchstens 50 Millimeter und, in einer besonders vorteilhaften Ausgestaltung, höchstens 40 Millimeter. Ferner ist das Sensorfeld vorzugsweise zumindest im Wesentlichen geradlinig ausgebildet. Dabei soll unter "zumindest im Wesentlichen geradlinig" insbesondere verstanden werden, dass zumindest eine gedachte Gerade existiert, die sämtliche Sensorelemente des Sensorfelds, die zu einer Erfassung der Berührposition vorgesehen sind, zumindest berührt.

Vorzugsweise ist das berührungsempfindliche Sensorfeld mit kapazitiv wirkenden Sensorelementen ausgestattet. Grundsätzlich ist aber auch eine Verwendung von resistiv, induktiv, piezo-elektrisch oder thermo-elektrisch wirkenden Sensorelementen oder eine beliebige Kombination von Sensorelementen der aufgeführten Wirkungsweisen denkbar.

Weiterhin wird vorgeschlagen, dass das Steuersignal in zumindest einem Betriebszustand der Steuereinheit eine wiederholte Inkrementierung oder eine wiederholte Dekrementierung einer Stellgröße zumindest initiiert. Unter einer "wiederholten Inkrementierung (Dekrementierung)" der Stellgröße soll in diesem Zusammenhang insbesondere verstanden werden, dass die Stellgröße in periodischen Zeitabständen um einen vorbestimmten Betrag erhöht (verringert) wird. Unter "zumindest initiiert" soll in diesem Zusammenhang insbesondere verstanden werden, dass das Steuersignal eine kausale Ursache für die wiederholte Inkrementierung (Dekrementierung) darstellt. Insbesondere kann eine tatsächliche Erhöhung der Stellgröße durch ein Stellmittel erfolgen, das in spezieller Weise zu einer Durchführung der Erhöhung ausgestattet ist. Beispielsweise kann die Stellgröße von einer elektrischen Leistung gebildet und die Steuereinheit dazu vorgesehen sein, ein Steuersignal zu einer Ansteuerung eines Leistungsstellers zu erzeugen, der die elektrische Leistung bereitstellt. Unter "wiederholte Inkrementierung oder wiederholte Dekrementierung" soll in diesem Zusammenhang insbesondere verstanden werden, dass die Steuereinheit sowohl zur Erzeugung eines Steuersignals zur wiederholten Inkrementierung als auch zur Erzeugung eines Steuersignals zur wiederholten Dekrementierung vorgesehen ist und dass ein Steuersignal zu einer wiederholten Inkrementierung und ein Steuersignal zu einer wiederholten Dekrementierung in zeitlich aufeinander folgender Weise durch die Steuereinheit erzeugbar sind. Dadurch kann eine besonders komfortable Bedienung der Hausgerätevorrichtung erzielt werden.

Gemäß der Erfindung ist die Steuereinheit dazu vorgesehen, in zumindest einem Betriebsmodus aus einer zeitlichen Abfolge von erfassten Berührpositionen eine Bewegungskenngröße zu bestimmen und das Steuersignal abhängig von der bestimmten Bewegungskenngröße zu gestalten. Als "Bewegungskenngrößen" sollen in diesem Zusammenhang insbesondere eine Bewegungsrichtung, eine Bewegungsgeschwindigkeit oder eine Bewegungsbeschleunigung in Betracht kommen. Grundsätzlich sind aber auch andere, unter Verwendung von Berührpositionen und einer Bestimmung von Zeitpunkten oder zeitlichen Abständen von Berührungen bestimmbare Bewegungskenngrößen denkbar. Dadurch kann bei einer geeigneten Ausgestaltung eine komfortable und sehr flexible Bedienung der Hausgerätevorrichtung erreicht werden. Besonders vorteilhaft ist die Steuereinheit dazu vorgesehen, das Steuersignal in Abhängigkeit von einer absoluten Größe einer bestimmten Bewegungskenngröße zu gestalten. Wenn beispielsweise die Bewegungskenngröße von einer Bewegungsgeschwindigkeit gebildet ist, kann die Steuereinheit von der absoluten Größe der Bewegungsgeschwindigkeit abhängige Steuersignale erzeugen, so dass unterschiedliche Funktionen der Hausgerätevorrichtung mit unterschiedlich schnellen Berührungen des Sensorfelds aktivierbar sein können.

Zudem wird vorgeschlagen, dass die Steuereinheit dazu vorgesehen ist, eine absolute Schrittweite der wiederholten Inkrementierung oder der wiederholten Dekrementierung der Stellgröße in Abhängigkeit von einem absoluten Betrag der durch die Steuereinheit bestimmten Bewegungskenngröße vorzugeben. Damit kann eine schnellere Einstellung eines gewünschten Zustands der Hausgerätevorrichtung erreicht werden, wodurch sich deren Bedienkomfort erhöht. Anstatt eine absolute Schrittweite der Stellgröße der in periodischen Zeitabständen wiederholten Inkrementierung oder der wiederholten Dekrementierung der Stellgröße vorzugeben, kann die Steuereinheit auch dazu vorgesehen sein, die periodischen Zeitabstände der wiederholten Inkrementierung oder der wiederholten Dekrementierung der Stellgröße in Abhängigkeit von einem absoluten Betrag der aus der zeitlichen Abfolge der erfassten Berührpositionen bestimmten Bewegungskenngröße vorzugeben. Wird beispielsweise die Bewegungskenngröße von einer Bewegungsgeschwindigkeit gebildet und bestimmt die Steuereinheit aus der zeitlichen Abfolge der erfassten Berührpositionen eine Bewegungsgeschwindigkeit, die aufgrund eines Vergleichs mit in der Steuereinheit hinterlegten Referenzwerten als hoch mit einer positiven Richtung bewertet ist, kann die Steuereinheit dazu vorgesehen sein, die absolute Schrittweite der wiederholten Inkrementierung der Stellgröße zu erhöhen. Alternativ kann die Steuereinheit in diesem Fall dazu vorgesehen sein, den periodischen Zeitabstand der wiederholten Inkrementierung der Stellgröße zu verringern. Grundsätzlich ist auch denkbar, dass die Steuereinheit dazu vorgesehen ist, ein Steuersignal zu erzeugen, das eine Kombination aus einer Erhöhung der absoluten Schrittweite der wiederholten Inkrementierung der Stellgröße und einer Verringerung des periodischen Zeitabstands der wiederholten Inkrementierung der Stellgröße darstellt.

Wenn das Sensorfeld höchstens vier Sensorelemente zum Erfassen der Berührposition auf dem Sensorfeld aufweist, kann bei hohem Bedienkomfort eine besonders einfache und kostengünstige Lösung bereitgestellt werden. Besonders vorteilhaft weist das Sensorfeld zwei Sensorelemente zum Erfassen der Berührposition auf dem Sensorfeld auf.

Wenn die höchstens vier Sensorelemente zum Erfassen der Berührposition auf dem Sensorfeld in der Richtung der Bewegungskenngröße voneinander beabstandet angeordnet sind, kann in besonders einfacher Weise eine zeitliche Abfolge von Berührpositionen zur Bestimmung der Bewegungskenngröße erfasst werden.

Ferner wird vorgeschlagen, dass die Steuereinheit dazu vorgesehen ist, zur Bestimmung der Bewegungskenngröße zumindest eine Zeitdauer zwischen einer Aktivierung eines ersten berührungsempfindlichen Sensorelements und einer Aktivierung zumindest eines zweiten berührungsempfindlichen Sensorelements des Sensorfelds zu verwenden. Dadurch kann eine Bestimmung der Bewegungskenngröße und insbesondere einer Bewegungsgeschwindigkeit in besonders flexibler Weise ausgestaltet werden.

Wenn die Steuereinheit dazu vorgesehen ist, bei einer Annäherung an zumindest einen vorbestimmten Grenzwert der Stellgröße die absolute Schrittweite in Abhängigkeit von einem Abstand eines momentanen Werts der Stellgröße zu dem vorbestimmten Grenzwert der Stellgröße zu verändern, kann ein besonders hoher Bedienkomfort erzielt werden. Beispielsweise kann eine Erhöhung der Stellgröße in einer Weise erfolgen, die einer Einstellung mit einem analogen Drehknopf entspricht, der anfänglich mit einer hohen Anfangsumdrehungszahl betätigt wird, selbsttätig langsamer wird und in einer Nähe eines gewünschten Werts anhält, was von einem Benutzer als eine besonders effiziente und komfortable Einstellmöglichkeit wahrgenommen werden kann. Bevorzugt ist der zumindest eine vorbestimmte Grenzwert der Stellgröße in der Steuereinheit hinterlegt.

Alternativ kann die Steuereinheit dazu vorgesehen sein, bei der Annäherung an den zumindest einen vorbestimmten Grenzwert der Stellgröße den periodischen Zeitabstand der wiederholten Inkrementierung der Stellgröße zu vergrößern. Grundsätzlich ist auch denkbar, dass die Steuereinheit dazu vorgesehen ist, bei der Annäherung an den zumindest einen vorbestimmten Grenzwert der Stellgröße ein Steuersignal zu erzeugen, das eine Kombination aus einer Verringerung der absoluten Schrittweite der wiederholten Inkrementierung der Stellgröße und einer Erhöhung des periodischen Zeitabstands der wiederholten Inkrementierung der Stellgröße darstellt.

Wenn die Stellgröße in zumindest einem Betriebsmodus eine einstellbare Vorwahlzeit einer Timerfunktion ist, kann der Bedienkomfort der Hausgerätevorrichtung weiter erhöht werden. Ferner wird vorgeschlagen, dass die Steuereinheit dazu vorgesehen ist, bei innerhalb eines vorbestimmten Zeitintervalls aufeinander folgenden Bestimmungen von Bewegungskenngrößen, deren absolute Größe innerhalb eines vorbestimmten Bereichs liegt, ein Steuersignal bereitzustellen, das einen Anstieg einer absoluten Schrittweite der wiederholten Inkrementierung oder der wiederholten Dekrementierung der einstellbaren Vorwahlzeit der Timerfunktion in vorgegebener Weise zumindest initiiert, wodurch sich der Bedienkomfort der Timerfunktion erhöhen lässt.

Außerdem wird vorgeschlagen, dass die Steuereinheit dazu vorgesehen ist, in zumindest einem Betriebsmodus aus einer zeitlichen Abfolge von durch ein einziges Sensorelement auf dem Sensorfeld erfassten Berührpositionen eine Bewegungskenngröße zu bestimmen. Dadurch kann eine Lösung bereitgestellt werden, die durch eine Verringerung der Anzahl von Bauelementen vereinfacht und platzsparend ausgeführt werden kann.

Wenn die Steuereinheit ferner eine Schrittstelleinheit umfasst und dazu vorgesehen ist, bei einer Aktivierung der Schrittstelleinheit ein Steuersignal bereitzustellen, das eine Inkrementierung oder eine Dekrementierung um eine vorbestimmte absolute Schrittweite zumindest initiiert, kann der Bedienkomfort der Hausgerätevorrichtung weiter gesteigert werden.

Ferner wird ein Hausgerät mit einer der beschriebenen Hausgerätevorrichtungen vorgeschlagen.

Zudem wird ein Verfahren zum Betrieb einer Hausgerätevorrichtung gemäß dem Anspruch 1 vorgeschlagen, bei dem die Steuereinheit abhängig von der erfassten Berührposition ein Steuersignal bereitstellt, das eine wiederholte Inkrementierung oder eine wiederholte Dekrementierung einer Stellgröße zumindest initiiert.

Weitere Vorteile ergeben sich aus den folgenden Zeichnungsbeschreibungen. In den Zeichnungen sind mehrere Ausführungsbeispiele der Erfindung dargestellt. Die Zeichnungen, die Beschreibungen und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein als Kochfeld ausgebildetes Hausgerät mit einer Hausgerätevorrichtung, die von einer Kochfeldvorrichtung gebildet ist, in einer Draufsicht,
- Fig. 2: eine Detailansicht eines Sensorfelds der Hausgerätevorrichtung gemäß der Fig. 1,
- Fig. 3: ein Diagramm zur Abhängigkeit einer absoluten Schrittweite einer wiederholten Inkrementierung von einer Bewegungskenngröße,
- Fig. 4: ein Diagramm mit zwei alternativen Stellkurven einer Steuereinheit der Hausgerätevorrichtung gemäß der Fig. 1,
- Fig. 5: ein Diagramm zur Bestimmung von Grenzwerten einer Stellgröße durch die Steuereinheit,
- Fig. 6: eine alternative Ausführungsform eines Sensorfelds der Hausgerätevorrichtung gemäß der Fig. 1 und
- Fig. 7: eine weitere alternative Ausführungsform eines Sensorfelds der Hausgerätevorrichtung gemäß der Fig. 1.

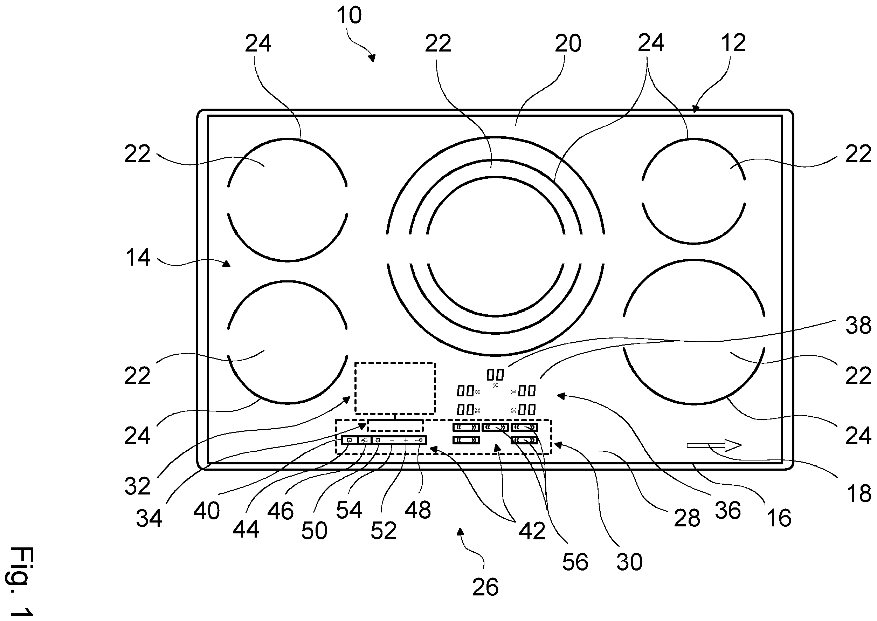

In Figur 1 ist ein als Kochfeld 10 ausgebildetes Hausgerät mit einer Hausgerätevorrichtung, die von einer Kochfeldvorrichtung 12 gebildet ist, in einer Ansicht von oben dargestellt. Die Kochfeldvorrichtung 12 weist eine Glaskeramikeinheit 14 auf, die eine Kochfeldplatte 20 mit fünf Kochzonen 22 bildet, deren Positionen auf der Kochfeldplatte 20 mit einem von Ringteilen gebildeten Dekor 24 angezeigt werden. Auf den Kochzonen 22 der Kochfeldplatte 20 können Gargeschirre zur Zubereitung von Speisen positioniert und mit unterhalb der Kochzonen 22 in bekannter Weise angeordneten und betreibbaren, nicht dargestellten Heizelementen erwärmt werden. Eine der Kochzonen 22 ist in einer zentralen Position der Kochfeldplatte 20 angeordnet. Zu beiden Seiten der zentral angeordneten Kochzone 22 befinden sich jeweils zwei kleinere, hintereinander angeordnete Kochzonen 22. Die Kochfeldvorrichtung 12 weist weiterhin eine Leistungsstelleinheit 32 zur Versorgung der Heizelemente mit elektrischer Energie auf.

In einem vorderen, zentralen Bereich 28 ist die Kochfeldvorrichtung 12 mit einer Bedieneinheit 26 ausgestattet. Die Bedieneinheit 26 umfasst mehrere berührungsempfindliche Sensorfelder 42 mit berührungsempfindlichen, kapazitiv wirkenden Sensorelementen 44-54, 60, 62. Berührt ein Bediener eines der berührungsempfindlichen Sensorfelder 42 an einer Berührposition, wird die Berührposition auf dem Sensorfeld 42 von einem der berührungsempfindlichen Sensorelemente 44-54, 60, 62 erfasst.

Die Kochfeldvorrichtung 12 weist ferner eine Steuereinheit 30 auf, die dazu vorgesehen ist, die erfassten Berührpositionen auf den Sensorfeldern 42 auszuwerten und in Abhängigkeit von den erfassten Berührpositionen Steuersignale zu erzeugen. Die Steuersignale dienen unter anderem dazu, die Leistungsstelleinheit 32 der Kochfeldvorrichtung 12 anzusteuern oder einen Betriebsmodus der Steuereinheit 30 festzulegen, wie nachfolgend ausführlich erläutert wird.

In einem linken Teil umfasst die Bedieneinheit 26 ein als Funktionsauswahlfeld 40 ausgebildetes Sensorfeld 42 mit seitlich nebeneinander angeordneten, berührungsempfindlichen, kapazitiv wirkenden Sensorelementen 44-54. Eine seitliche Richtung 18 verläuft parallel zu einer Vorderkante 16 der Kochfeldplatte 20. Durch eine Berührung einiger der Sensorelemente 44-54 des Funktionsauswahlfelds 40 kann einer der Betriebsmodi der Steuereinheit 30 festgelegt werden. So ist das am äußersten linken Rand des Funktionsauswahlfelds 40 angeordnete Einschalt-Sensorelement 44 dazu vorgesehen, bei Aktivierung durch Berührung den Betriebsmodus der Steuereinheit 30 in bekannter Weise zwischen einem Bereitschaftsmodus und einem Einschaltmodus zu wechseln. Das rechts vom Einschalt-Sensorelement 44 angeordnete Reinigungsschutz-Sensorelement 46 ist dazu vorgesehen, bei Aktivierung durch Berührung den Betriebsmodus der Steuereinheit 30 in bekannter Weise zwischen dem Einschaltmodus und einem Reinigungsschutzmodus zu wechseln, in dem ausgewählte, an der Bedieneinheit 26 vornehmbare Einstellungsmöglichkeiten für eine vorbestimmte Zeitdauer von 35 Sekunden zu Reinigungszwecken ausgesetzt sind. Das am äußersten rechten Rand des Funktionsauswahlfelds 40 angeordnete Kindersicherungs-Sensorelement 48 ist dazu vorgesehen, den Betriebsmodus der Steuereinheit 30 durch Berührung von einer Zeitdauer von mehr als fünf Sekunden in bekannter Weise zwischen dem Einschaltmodus und einem Kindersicherungsmodus oder dem Bereitschaftsmodus und dem Kindersicherungsmodus zu wechseln.

In einem rechten Bereich weist die Bedieneinheit 26 fünf als Schiebesensoren 56 ausgebildete Sensorfelder 42 auf, die den Kochzonen 22 zugeordnet sind. Die geometrische Anordnung der Schiebesensoren 56 ist der Anordnung der Kochzonen 22 nachempfunden, um dem Bediener eine intuitive Bedienung zu ermöglichen.

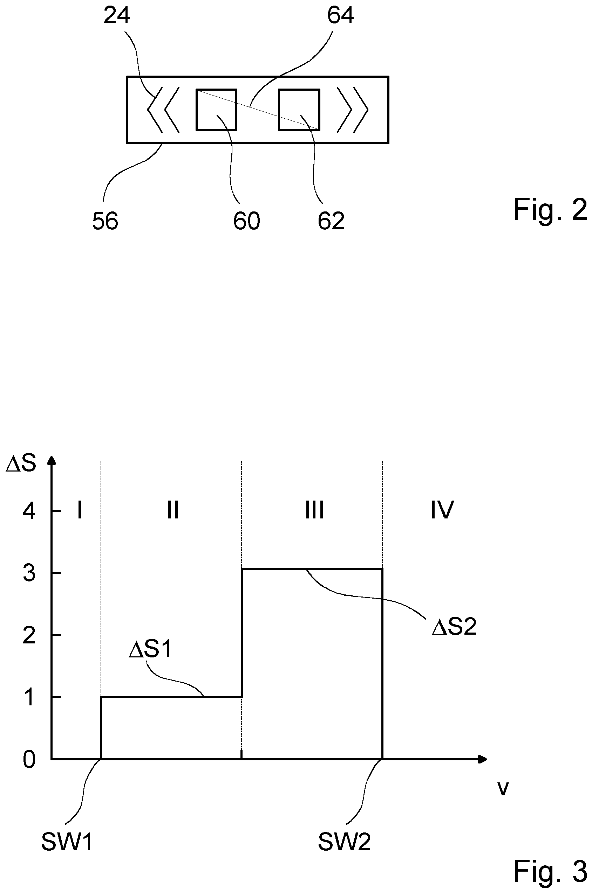

Die Schiebesensoren 56 sind in identischer Weise ausgebildet. Jeder Schiebesensor 56 weist die zwei berührungsempfindlichen Sensorelemente 60, 62 auf, die in seitlicher Richtung 18 voneinander beabstandet sind und deren berührungsempfindliche Flächen von oben gesehen eine quadratische Form aufweisen (Fig. 2). Eine diagonal zwischen berührungsempfindlichen Teilen des als Schiebesensor 56 ausgebildeten Sensorfelds 42 verlaufende maximale lineare Erstreckung 64, die durch einen Abstand zwischen gegenüberliegenden Ecken der Sensorelemente 60, 62 des Schiebesensors 56 gebildet ist, beträgt 32 Millimeter.

Im Einschaltmodus der Steuereinheit 30 kann eine Bedienung der Kochfeldvorrichtung 12 durch eine im Wesentlichen parallel zur seitlichen Richtung 18 geführte, gleitend berührende Bewegung des Bedieners über einen der Schiebesensoren 56 erfolgen. Durch diese Bewegung werden zunächst das eine der beiden Sensorelemente 60, 62 und danach, in einem zeitlichen Abstand, das andere der beiden Sensorelemente 60, 62 des Schiebesensors 56 berührt und Berührpositionen auf den als Schiebesensoren 56 ausgebildeten Sensorfeldern 42 in einem zeitlichen Abstand erfasst.

Die Steuereinheit 30 ist dazu vorgesehen, im Einschaltmodus aus einer zeitlichen Abfolge der erfassten Berührpositionen eine Bewegungskenngröße, die von einer Bewegungsgeschwindigkeit v in der seitlichen Richtung 18 gebildet ist, zu bestimmen und das Steuersignal abhängig von der bestimmten Bewegungskenngröße entsprechend der folgenden Beschreibung zu gestalten. Die erfasste Bewegungsgeschwindigkeit v in der seitlichen Richtung 18 weist einen Betrag und ein Richtungsvorzeichen auf, das bei einer Bewegung von links nach rechts als positiv und bei einer Bewegung von rechts nach links als negativ definiert ist.

Die Steuereinheit 30 umfasst des Weiteren eine Schrittstelleinheit 34 und ist dazu vorgesehen, bei einer Aktivierung der Schrittstelleinheit 34 ein Steuersignal bereitzustellen, das eine Inkrementierung oder eine Dekrementierung um eine vorbestimmte absolute Schrittweite ΔS1, ΔS2, ΔS3 zumindest initiiert.

Liegt der Betrag einer erfassten ersten Bewegungsgeschwindigkeit v unterhalb eines in der Steuereinheit 30 hinterlegten ersten Schwellenwerts SW1 (Fig. 3), ist die Steuereinheit 30 dazu vorgesehen, die Berührungen der Sensorelemente 60, 62 des Schiebesensors 56 als Einzelberührungen zu interpretieren. Im Einschaltmodus der Steuereinheit 30 kann durch eine Einzelberührung eine dem Schiebesensor 56 zugeordnete Kochzone 22 ausgewählt werden.

Liegt der Betrag der erfassten ersten Bewegungsgeschwindigkeit v oberhalb eines in der Steuereinheit 30 hinterlegten zweiten Schwellenwerts SW2, ist die Steuereinheit 30 dazu vorgesehen, die Berührungen der Sensorelemente 60, 62 des Schiebesensors 56 als gleichzeitige Berührung beider Sensorelemente 60, 62 zu interpretieren. Im Einschaltmodus der Steuereinheit 30 kann durch eine gleichzeitige Berührung beider Sensorelemente 60, 62 eine dem Schiebesensor 56 zugeordnete Kochzone 22 ausgewählt werden.

Ist eine der Kochzonen 22 durch Berührung des ihr zugeordneten Schiebesensors 56 ausgewählt, liegt ein Betrag einer erfassten Bewegungsgeschwindigkeit v einer zweiten Bewegung oberhalb des in der Steuereinheit 30 hinterlegten ersten Schwellenwerts SW1 und unterhalb des in der Steuereinheit 30 hinterlegten zweiten Schwellenwerts SW2 und ist ein Richtungsvorzeichen der erfassten Bewegungsgeschwindigkeit v der zweiten Bewegung positiv, ist die Steuereinheit 30 dazu vorgesehen, der Leistungsstelleinheit 32 durch Aktivierung der Schrittstelleinheit 34 ein Steuersignal bereitzustellen, das eine wiederholte Inkrementierung einer als Heizleistung P der Kochzone 22 ausgebildeten Stellgröße initiiert, die durch die Leistungsstelleinheit 32 umgesetzt wird.

Ist eine der Kochzonen 22 durch Berührung des ihr zugeordneten Schiebesensors 56 ausgewählt, liegt der Betrag der erfassten Bewegungsgeschwindigkeit v der zweiten Bewegung oberhalb des in der Steuereinheit 30 hinterlegten ersten Schwellenwerts SW1 und unterhalb des in der Steuereinheit 30 hinterlegten zweiten Schwellenwerts SW2 und ist das Richtungsvorzeichen der erfassten Bewegungsgeschwindigkeit v der zweiten Bewegung negativ, ist die Steuereinheit 30 dazu vorgesehen, der Leistungsstelleinheit 32 durch Aktivierung der Schrittstelleinheit 34 ein Steuersignal bereitzustellen, das eine wiederholte Dekrementierung der als Heizleistung P der Kochzone 22 ausgebildeten Stellgröße initiiert, die durch die Leistungsstelleinheit 32 umgesetzt wird.

Die Bedieneinheit 26 weist in ihrem rechten Bereich ferner eine Anzeigeeinheit 36 mit fünf Anzeigeelementen 38 auf (Fig. 1), mit der momentane Werte der als Heizleistung P der Kochzonen 22 ausgebildeten Stellgrößen in digitaler Form darstellbar sind. Die Heizleistung P ist in bekannter Weise kodiert durch eine relative Bezugszahl angegeben, wobei die Zahl "1" einer ersten, von Null verschiedenen Heizleistung P, und die Zahl "17" einer der Kochzone 22 von der Leistungsstelleinheit 32 maximal zur Verfügung gestellten Heizleistung Pₘₐₓ entspricht. Die geometrische Anordnung der Anzeigeelemente 38 ist der Anordnung der Kochzonen 22 nachempfunden, um eine rasche Zuordnung individueller Heizleistungen P zu den Kochzonen 22 durch den Bediener zu erleichtern.

Der Vorgang der wiederholten Inkrementierung oder Dekrementierung erfolgt mit einer Stellfrequenz, die in der Steuereinheit 30 hinterlegt ist. Die Steuereinheit 30 ist ferner dazu vorgesehen, die absolute Schrittweite ΔS1, ΔS2, ΔS3 der wiederholten Inkrementierung oder der wiederholten Dekrementierung der Stellgröße in Abhängigkeit von einem absoluten Betrag der durch die Steuereinheit 30 bestimmten Bewegungskenngröße, die von der Bewegungsgeschwindigkeit v der Bewegung gebildet ist, vorzugeben.

Fig. 3 zeigt eine Abhängigkeit der absoluten Schrittweite ΔS1, ΔS2, ΔS3 der wiederholten Inkrementierung oder Dekrementierung vom Betrag der erfassten Bewegungsgeschwindigkeit v. Bei einer erfassten Bewegungsgeschwindigkeit v in einem Geschwindigkeitsbereich I werden, wie zuvor beschrieben, die Berührungen der Sensorelemente 60, 62 des Schiebesensors 56 als Einzelberührungen interpretiert, und es wird keine wiederholte Inkrementierung oder Dekrementierung durch die Steuereinheit 30 initiiert. Bei einer Bewegungsgeschwindigkeit v in einem Geschwindigkeitsbereich II wird eine wiederholte Inkrementierung oder Dekrementierung mit einer ersten, geringeren absoluten Schrittweite ΔS1 durch die Steuereinheit 30 initiiert. Liegt die erfasste Bewegungsgeschwindigkeit v in einem Geschwindigkeitsbereich III, erzeugt die Steuereinheit 30 ein Steuersignal, das eine wiederholte Inkrementierung oder Dekrementierung mit einer zweiten, größeren absoluten Schrittweite ΔS2 initiiert. Für den Fall, dass eine Bewegungsgeschwindigkeit v in einem Geschwindigkeitsbereich IV erfasst wird, ist die Steuereinheit 30, wie zuvor beschrieben, dazu vorgesehen, die Berührungen der Sensorelemente 60, 62 des Schiebesensors 56 als gleichzeitige Berührung beider Sensorelemente 60, 62 zu interpretieren und keine wiederholte Inkrementierung oder Dekrementierung zu initiieren.

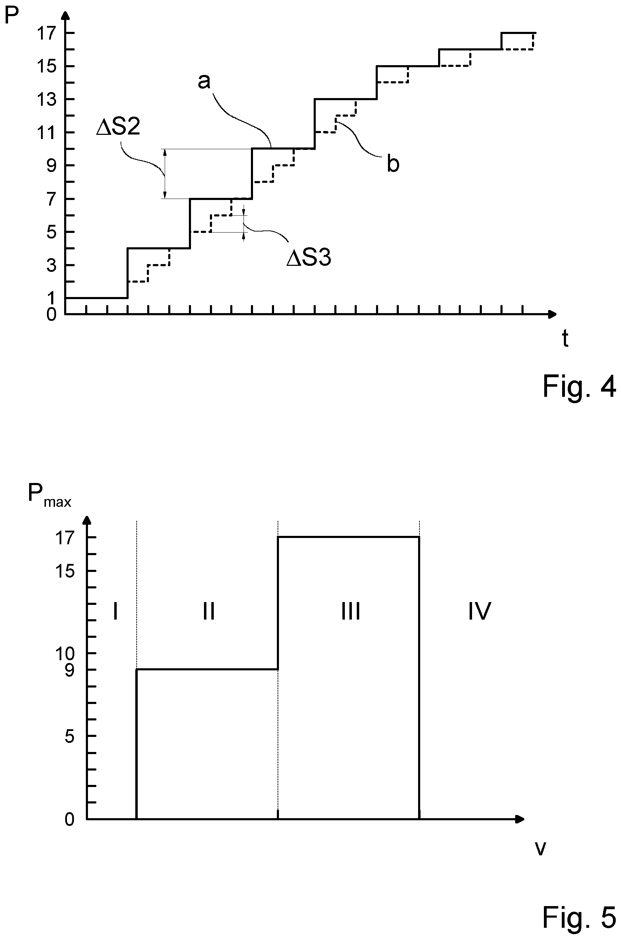

In Fig. 4 sind für eine feste Bewegungsgeschwindigkeit v aus dem Geschwindigkeitsbereich II der Fig. 3 zwei alternative Stellkurven a, b der Steuereinheit 30 in Abhängigkeit von der Zeit t angegeben, durch die die Abhängigkeit der Inkrementierung der Stellgröße festgelegt ist. Die beiden Stellkurven a, b unterscheiden sich darin, dass eine Stellfrequenz der zweiten Stellkurve b einer dreifachen Stellfrequenz der ersten Stellkurve a entspricht, die Schrittweite ΔS3 der zweiten Stellkurve b jedoch nur ein Drittel der Schrittweite ΔS2 der ersten Stellkurve a ausmacht. Die erste Stellkurve a bietet den Vorteil einer ruhigen Anzeige, während die zweite Stellkurve b den Vorteil aufweist, dass der Bediener während der Inkrementierung der Stellgröße in einer feineren Auflösungsstufe eingreifen kann, wie im Folgenden beschrieben wird.

Die durch die zwei Berührungsbewegungen auf dem Sensorfeld 42 ausgelöste wiederholte Inkrementierung der als Heizleistung P der Kochzone 22 ausgebildeten Stellgröße kann durch eine erneute Berührung des der Kochzone 22 zugeordneten Schiebesensors 56 angehalten werden. Die Heizleistung P entspricht dann der Stellgröße nach dem zuletzt erfolgten Inkrementierungsschritt. Durch eine erneute Berührungsbewegung in der seitlichen Richtung 18 mit einem absoluten Betrag der Bewegungsgeschwindigkeit v, der in den Geschwindigkeitsbereichen II oder III liegt, und mit einem positiven Richtungsvorzeichen kann der Bediener eine bekannte Schnellaufheizfunktion ("booster") aktivieren, in der die Steuereinheit 30 ein Steuersignal erzeugt, das für eine in der Steuereinheit 30 hinterlegte Zeitdauer eine maximal verfügbare Heizleistung Pₘₐₓ der Kochzone 22 initiiert und nach Ablauf der Zeitdauer wieder zu der Heizleistung P nach dem zuletzt erfolgten Inkrementierungsschritt der wiederholten Inkrementierung zurückkehrt.

Wird die durch die zwei Berührungsbewegungen auf dem Sensorfeld 42 ausgelöste wiederholte Inkrementierung der als Heizleistung P der Kochzone 22 ausgebildeten Stellgröße nicht von dem Bediener durch eine erneute Berührung angehalten, nähert sich die als Heizleistung P der Kochzone 22 ausgebildete Stellgröße einem vorbestimmten Grenzwert der Stellgröße, der von der durch die Steuereinheit 30 vorgegebenen, maximal verfügbaren Heizleistung Pₘₐₓ gebildet ist. Der vorbestimmte Grenzwert der Stellgröße ist von einem absoluten Betrag der Bewegungsgeschwindigkeit v abhängig und in der Steuereinheit 30 in Form einer Funktionstafel gemäß Fig. 5 hinterlegt. Die Steuereinheit 30 ist dazu vorgesehen, in Abhängigkeit von einem absoluten Betrag der durch die Steuereinheit 30 bestimmten Bewegungsgeschwindigkeit v den entsprechenden Grenzwert aus der Funktionstafel zu bestimmen. Bei einer Annäherung eines momentanen Werts der Stellgröße an den vorbestimmten Grenzwert der Stellgröße ist die Steuereinheit 30 dazu vorgesehen, die absolute Schrittweite ΔS1, ΔS2, ΔS3 der wiederholten Inkrementierung oder der wiederholten Dekrementierung der Stellgröße in Abhängigkeit von einem Abstand des momentanen Werts der Stellgröße zu dem vorbestimmten Grenzwert der Stellgröße zu verändern, indem die absolute Schrittweite ΔS1, ΔS2, ΔS3 umso mehr verringert wird, je geringer der Abstand des momentanen Werts der Stellgröße zu dem vorbestimmten Grenzwert der Stellgröße ist (rechter Bereich der Stellkurve a in der Fig. 4). Dadurch wird eine Einstellung der Stellgröße durch den Bediener ermöglicht, die von diesem als besonders komfortabel empfunden wird. In Entsprechung zu den beiden Stellkurven a, b gemäß der Fig. 4 ist alternativ auch eine Verringerung der Stellfrequenz möglich (rechter Teil der Stellkurve b in der Fig. 4).

In dem als Funktionsauswahlfeld 40 ausgebildeten Sensorfeld 42 der Bedieneinheit 26 ist das als Timer-Sensorelement 50 ausgebildete, berührungsempfindliche, kapazitiv wirkende Sensorelement beinhaltet, durch dessen Aktivierung durch eine Berührung für jede der Kochzonen 22 in der Steuereinheit 30 ein zugeordneter Timer-Betriebsmodus einstellbar ist. Im Timer-Betriebsmodus ist die Steuereinheit 30 dazu vorgesehen, die absolute Schrittweite ΔS1, ΔS2, ΔS3 der wiederholten Inkrementierung oder der wiederholten Dekrementierung der von einer einstellbaren Vorwahlzeit einer Timerfunktion gebildeten Stellgröße in Abhängigkeit von einem absoluten Betrag der durch die Steuereinheit 30 bestimmten Bewegungskenngröße vorzugeben. Die von der Steuereinheit 30 bestimmte Bewegungskenngröße wird von dem Betrag der Bewegungsgeschwindigkeit v einer im Wesentlichen in der seitlichen Richtung geführten, gleitend berührenden Bewegung durch den Bediener gebildet. Durch eine erste solche Bewegung, deren Betrag der Bewegungsgeschwindigkeit v innerhalb des Geschwindigkeitsbereichs II gemäß der Fig. 3 liegt, durch den Bediener über den der Kochzone 22 zugeordneten Schiebesensor 56 wird die Vorwahlzeit der Timerfunktion auf den Wert "1 min" gesetzt. Die Steuereinheit 30 gibt als absolute Schrittweite ΔS1, ΔS2, ΔS3 der wiederholten Inkrementierung den Wert "1 min" vor, so dass die Vorwahlzeit mit einer vorbestimmten Taktfrequenz erhöht wird. Die Erhöhung kann durch eine zweite Berührung des der Kochzone 22 zugeordneten Schiebesensors 56 durch den Bediener, deren Betrag der Bewegungsgeschwindigkeit v innerhalb des Geschwindigkeitsbereichs I gemäß der Fig. 3 liegt, bei einer gewünschten Vorwahlzeit angehalten werden.

Führt stattdessen der Bediener innerhalb eines vorbestimmten Zeitintervalls von fünf Sekunden eine zweite, im Wesentlichen von links nach rechts in der seitlichen Richtung 18 geführte, gleitend berührende Bewegung über den der Kochzone 22 zugeordneten Schiebesensor 56 mit einem Betrag der Bewegungsgeschwindigkeit v, der innerhalb des Geschwindigkeitsbereichs II gemäß der Fig. 3 liegt, durch, ist die Steuereinheit 30 dazu vorgesehen, ein Steuersignal bereitzustellen, durch das ein einmaliger Anstieg der absoluten Schrittweite ΔS1, ΔS2, ΔS3 der wiederholten Inkrementierung der Vorwahlzeit von "1 min" auf "10 min" ausgeführt wird. Ist beispielsweise nach der ersten berührenden Bewegung die Vorwahlzeit der Timerfunktion durch die wiederholte Inkrementierung auf den Wert "3 min" angestiegen, wird nach der zweiten berührenden Bewegung die Vorwahlzeit der Timerfunktion durch die zeitlich darauf folgende Inkrementierung auf den Wert "13 min" gesetzt und in den weiteren Inkrementierungsschritten wiederum um die Schrittweite "1 min" auf "14 min" erhöht.

Das als Funktionsauswahlfeld 40 ausgebildete Sensorfeld 42 der Bedieneinheit 26 umfasst ein mit einem Pluszeichen gekennzeichnetes, berührungsempfindliches, kapazitiv wirkendes Einzelschritt-Sensorelement 52. Die Steuereinheit 30 ist dazu vorgesehen, nach einem Anhalten bei einer gewünschten Vorwahlzeit der Timerfunktion oder einem Anhalten einer wiederholten Inkrementierung oder einer wiederholten Dekrementierung der als Heizleistung P einer der Kochzonen 22 ausgebildeten Stellgröße durch den Bediener bei jeder Berührung des mit dem Pluszeichen gekennzeichneten Einzelschritt-Sensorelements 52 die Stellgröße um eine vorbestimmte Schrittweite ΔS1, ΔS2, ΔS3 zu erhöhen.

Das als Funktionsauswahlfeld 40 ausgebildete Sensorfeld 42 der Bedieneinheit 26 umfasst ferner ein mit einem Minuszeichen gekennzeichnetes, berührungsempfindliches, kapazitiv wirkendes Einzelschritt-Sensorelement 54. Die Steuereinheit 30 ist dazu vorgesehen, nach einem Anhalten bei einer gewünschten Vorwahlzeit der Timerfunktion oder einem Anhalten einer wiederholten Inkrementierung oder einer wiederholten Dekrementierung der als Heizleistung P einer der Kochzonen 22 ausgebildeten Stellgröße durch den Bediener bei jeder Berührung des mit dem Minuszeichen gekennzeichneten Einzelschritt-Sensorfelds die Stellgröße um eine vorbestimmte Schrittweite ΔS1, ΔS2, ΔS3 zu verringern. Durch die Einzelschritt-Sensorelemente 54 ist in flexibler Weise eine Korrektur oder Neueinstellung der Stellgröße ermöglicht.

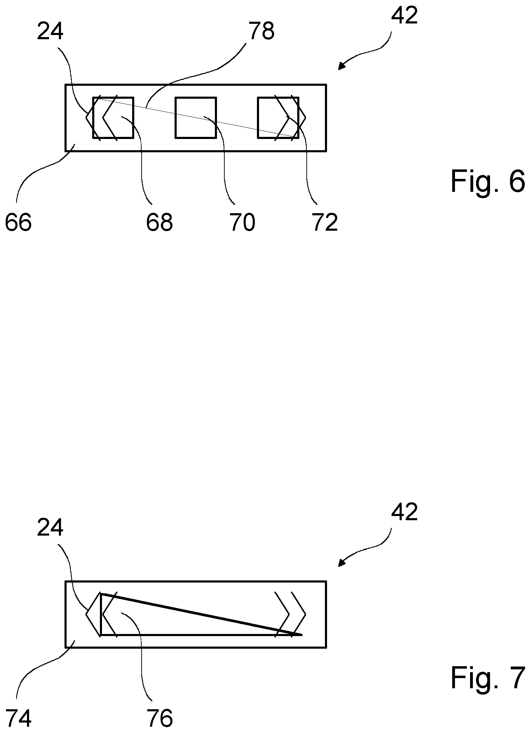

In Fig. 6 ist eine alternative Ausführungsform eines als Schiebesensor 66 ausgebildeten Sensorfelds 42 der Bedieneinheit 26 der Hausgerätevorrichtung gemäß der Fig. 1 dargestellt. Der Schiebesensor 66 umfasst drei berührungsempfindliche, kapazitiv wirkende Sensorelemente 68, 70, 72 zum Erfassen der Berührposition, die in der seitlichen Richtung 18 voneinander beabstandet angeordnet sind. Eine diagonal zwischen berührungsempfindlichen Teilen des als Schiebesensor 66 ausgebildeten Sensorfelds 42 verlaufende maximale lineare Erstreckung 78, die durch einen Abstand zwischen gegenüberliegenden Ecken des Sensorelements 68 und des Sensorelements 72 des Schiebesensors 66 gebildet ist, beträgt 51 Millimeter.

Die Steuereinheit 30 ist dazu vorgesehen, zur Bestimmung einer von der Bewegungsgeschwindigkeit v gebildeten Bewegungskenngröße sowohl eine Zeitdauer zwischen einer Aktivierung des ersten berührungsempfindlichen Sensorelements 68 und einer Aktivierung des zweiten berührungsempfindlichen Sensorelements 70 des als Schiebesensor 56 ausgebildeten Sensorfelds 42 als auch eine Zeitdauer zwischen einer Aktivierung des zweiten berührungsempfindlichen Sensorelements 70 und einer Aktivierung des dritten berührungsempfindlichen Sensorelements 72 des als Schiebesensor 66 ausgebildeten Sensorfelds 42 zu verwenden, und durch Mittelwertbildung aus den beiden von der Steuereinheit 30 bestimmten Bewegungsgeschwindigkeiten v eine mittlere Bewegungsgeschwindigkeit v zu ermitteln, wodurch vorteilhaft eine Volatilität der ermittelten Bewegungsgeschwindigkeit v der durch den Bediener ausgeführten Bewegungen eingeschränkt wird.

Fig. 7 zeigt eine weitere alternative Ausführungsform eines als Schiebesensor 74 ausgebildeten Sensorfelds 42 der Bedieneinheit 26 der Hausgerätevorrichtung gemäß der Fig. 1. Der Schiebesensor 74 umfasst ein einziges berührungsempfindliches, kapazitiv wirkendes Sensorelement 76 zum Erfassen der Berührposition. Das Sensorelement 76 weist in einer Richtung, die senkrecht zu der seitlichen Richtung 18 verläuft, eine Abmessung auf, die in der seitlichen Richtung 18 von links nach rechts linear abnimmt und in einem äußersten linken Randbereich geringer ist als eine durchschnittliche Abmessung eines Fingers des Bedieners. Dadurch kann erreicht werden, dass bei einer Berührung des Schiebesensors 74 durch den Bediener ein kapazitiver Messwert mit einer hohen Wahrscheinlichkeit einer Berührposition zugeordnet werden kann. Die Steuereinheit 30 ist dazu vorgesehen, im Einschaltmodus aus einer zeitlichen Abfolge der durch das einzige Sensorelement 76 auf dem Sensorfeld 42 erfassten Berührpositionen einer Bewegung des Bedieners die von der Bewegungsgeschwindigkeit v gebildete Bewegungskenngröße zu bestimmen.

**Bezugszeichen**

| | | | |
|---|---|---|---|
| 10 | Kochfeld | 64 | lineare Erstreckung |
| 12 | Kochfeldvorrichtung | 66 | Schiebesensor |
| 14 | Glaskeramikeinheit | 68 | Sensorelement |
| 16 | Vorderkante | 70 | Sensorelement |
| 18 | seitliche Richtung | 72 | Sensorelement |
| 20 | Kochfeldplatte | 74 | Schiebesensor |
| 22 | Kochzone | 76 | Sensorelement |
| 24 | Dekor | 78 | lineare Erstreckung |
| 26 | Bedieneinheit | P | Heizleistung |
| 28 | zentraler Bereich | Pₘₐₓ | maximale Heizleistung |
| 30 | Steuereinheit | V | Bewegungsgeschwindigkeit |
| 32 | Leistungsstelleinheit | I | Geschwindigkeitsbereich |
| 34 | Schrittstelleinheit | II | Geschwindigkeitsbereich |
| 36 | Anzeigeeinheit | III | Geschwindigkeitsbereich |
| 38 | Anzeigeelement | IV | Geschwindigkeitsbereich |
| 40 | Funktionsauswahlfeld | SW1 | Schwellenwert |
| 42 | Sensorfeld | SW2 | Schwellenwert |
| 44 | Einschalt-Sensorelement | ΔS1 | Schrittweite |
| 46 | Reinigungsschutz-Sensorelement | ΔS2 | Schrittweite |
| | | ΔS3 | Schrittweite |
| 48 | Kindersicherungs-Sensorelement | a | Stellkurve |
| | | b | Stellkurve |
| 50 | Timer-Sensorelement | t | Zeit |
| 52 | Einzelschritt-Sensorelement | | |
| 54 | Einzelschritt-Sensorelement | | |
| 56 | Schiebesensor | | |
| 60 | Sensorelement | | |
| 62 | Sensorelement | | |

## Patentansprüche

1. Kochfeld mit einer Hausgerätevorrichtung mit wenigstens einem berührungsempfindlichen Sensorfeld (42) mit zumindest einem berührungsempfindlichen Sensorelement (60, 62; 68, 70, 72; 76) zu einem Erfassen einer Berührposition auf dem Sensorfeld (42) und mit einer Steuereinheit (30) zum Erzeugen wenigstens eines Steuersignals in Abhängigkeit von der erfassten Berührposition, wobei die Steuereinheit (30) dazu vorgesehen ist, in zumindest einem Betriebsmodus aus einer zeitlichen Abfolge von erfassten Berührpositionen eine Bewegungskenngröße zu bestimmen und das Steuersignal abhängig von der bestimmten Bewegungskenngröße zu gestalten, wobei die Bewegungskenngröße von einer Bewegungsgeschwindigkeit (v) gebildet ist, wobei das Steuersignal in zumindest einem Betriebszustand der Steuereinheit (30) eine wiederholte Inkrementierung oder eine wiederholte Dekrementierung einer Stellgröße zumindest initiiert, wobei die Steuereinheit (30) dazu vorgesehen ist, eine absolute Schrittweite (ΔS1, ΔS2, ΔS3) der wiederholten Inkrementierung oder der wiederholten Dekrementierung der Stellgröße in Abhängigkeit von einem absoluten Betrag der durch die Steuereinheit (30) bestimmten Bewegungskenngröße vorzugeben, **dadurch gekennzeichnet, dass** das Sensorfeld (42) eine maximale lineare Erstreckung (64; 78) von maximal 70 Millimeter zwischen berührungsempfindlichen Teilen des Sensorfelds (42) zum Erfassen der Berührposition aufweist und wobei die Steuereinheit (30) dazu vorgesehen ist, bei einer Annäherung an zumindest einen vorbestimmten Grenzwert der Stellgröße die absolute Schrittweite (ΔS1, ΔS2, ΔS3) in Abhängigkeit von einem Abstand eines momentanen Werts der Stellgröße zu dem vorbestimmten Grenzwert der Stellgröße zu verändern.

2. Kochfeld nach Anspruch 1, **dadurch gekennzeichnet, dass** die höchstens vier Sensorelemente (60, 62; 68, 70, 72; 76) in der Richtung (18) der Bewegungskenngröße voneinander beabstandet angeordnet sind.

3. Kochfeld zumindest nach Anspruch 1, **dadurch gekennzeichnet, dass** die Steuereinheit (30) dazu vorgesehen ist, zur Bestimmung der Bewegungskenngröße zumindest eine Zeitdauer zwischen einer Aktivierung eines ersten berührungsempfindlichen Sensorelements (60, 62; 68, 70, 72; 76) und einer Aktivierung zumindest eines zweiten berührungsempfindlichen Sensorelements (60, 62; 68, 70, 72; 76) des Sensorfelds (42) zu verwenden.

4. Kochfeld zumindest nach Anspruch 1, **dadurch gekennzeichnet, dass** die Stellgröße in zumindest einem Betriebsmodus eine einstellbare Vorwahlzeit einer Timerfunktion ist.

5. Kochfeld zumindest nach Anspruch 4, **dadurch gekennzeichnet, dass** die Steuereinheit (30) dazu vorgesehen ist, bei innerhalb eines vorbestimmten Zeitintervalls aufeinanderfolgenden Bestimmungen von Bewegungskenngrößen, deren absolute Größe innerhalb eines vorbestimmten Bereichs liegt, ein Steuersignal bereitzustellen, das einen-Anstieg einer absoluten Schrittweite (ΔS1, ΔS2, ΔS3) für eine Inkrementierung oder eine Dekrementierung der Stellgröße in vorgegebener Weise zumindest initiiert.

6. Kochfeld zumindest nach Anspruch 1, **dadurch gekennzeichnet, dass** die Steuereinheit (30) dazu vorgesehen ist, in zumindest einem Betriebsmodus aus einer zeitlichen Abfolge von durch ein einziges Sensorelement (60, 62; 68, 70, 72; 76) auf dem Sensorfeld (42) erfassten Berührpositionen eine Bewegungskenngröße zu bestimmen.

7. Kochfeld nach einem der vorhergehenden Ansprüche, **dadurch gekennzeichnet, dass** die Steuereinheit (30) eine Schrittstelleinheit (34) umfasst und dazu vorgesehen ist, bei einer Aktivierung der Schrittstelleinheit (34) ein Steuersignal bereitzustellen, das eine Inkrementierung oder eine Dekrementierung um eine vorbestimmte absolute Schrittweite (ΔS1, ΔS2, ΔS3) zumindest initiiert.

## Claims

1. Hob with a household appliance apparatus with at least one touch-sensitive sensor field (42) with at least one touch-sensitive sensor element (60, 62; 68, 70, 72; 76) for acquiring a touch position on the sensor field (42) and with a control unit (30) for generating at least one control signal as a function of the acquired touch position, wherein the control unit (30) is provided, in at least one operating mode, to determine a movement characteristic variable from a temporal sequence of acquired touch positions and to configure the control signal as a function of the determined movement characteristic variable, wherein the movement characteristic variable is formed by a movement speed (v), wherein, in at least one operating state of the control unit (30), the control signal at least initiates a repeated incrementing or a repeated decrementing of a manipulated variable, wherein the control unit (30) is provided to predefine an absolute step size (ΔS1, ΔS2, ΔS3) of the repeated incrementing or the repeated decrementing of the manipulated variable as a function of an absolute value of the movement characteristic variable determined by the control unit (30), **characterised in that** the sensor field (42) has a maximum linear extension (64; 78) of a maximum of 70 millimetres between touch-sensitive parts of the sensor field (42) for acquiring the touch position, and wherein the control unit (30) is provided, when at least one predetermined limit value of the manipulated variable is approached, to modify the absolute step size (ΔS1, ΔS2, ΔS3) as a function of a spacing between an instantaneous value of the manipulated variable and the predetermined limit value of the manipulated variable.

2. Hob according to claim 1, **characterised in that** the at most four sensor elements (60, 62; 68, 70, 72; 76) are arranged such that they are spaced apart from one another in the direction (18) of the movement characteristic variable.

3. Hob at least according to claim 1, **characterised in that** the control unit (30) is provided, in order to determine the movement characteristic variable, to use at least a duration between an activation of a first touch-sensitive sensor element (60, 62; 68, 70, 72; 76) and an activation of at least a second touch-sensitive sensor element (60, 62; 68, 70, 72; 76) of the sensor field (42).

4. Hob at least according to claim 1, **characterised in that** the manipulated variable, in at least one operating mode, is an adjustable preselection time of a timer function.

5. Hob at least according to claim 4, **characterised in that** the control unit (30) is provided, in the case of movement characteristic variables being determined successively within a predetermined time interval, the absolute magnitude of which lies within a predetermined range, to provide a control signal which at least initiates an increase in an absolute step size (ΔS1, ΔS2, ΔS3) for an incrementing or a decrementing of the manipulated variable in a predefined manner.

6. Hob at least according to claim 1, **characterised in that** the control unit (30) is provided, in at least one operating mode, to determine a movement characteristic variable from a temporal sequence of touch positions acquired on the sensor field (42) by a single sensor element (60, 62; 68, 70, 72; 76).

7. Hob according to one of the preceding claims, **characterised in that** the control unit (30) comprises a step setting unit (34) and is provided, when the step setting unit (34) is activated, to provide a control signal which at least initiates an incrementing or a decrementing by a predetermined absolute step size (ΔS1, ΔS2, ΔS3).

## Revendications

1. Table de cuisson comportant un dispositif d'appareil ménager comprenant au moins un champ de détection (42) tactile ayant au moins un élément capteur tactile (60, 62 ; 68, 70, 72 ; 76) pour une détection d'une position de contact sur le champ de détection (42), et comprenant une unité de commande (30) destinée à générer au moins un signal de commande en fonction de la position de contact détectée, dans laquelle l'unité de commande (30) est ménagée, dans au moins un mode de fonctionnement, pour déterminer une grandeur caractéristique de mouvement à partir d'une séquence temporelle de positions de contact détectées, et pour concevoir le signal de commande en fonction de la grandeur caractéristique de mouvement déterminée, dans laquelle la grandeur caractéristique de mouvement est formée par une vitesse de mouvement (v), dans laquelle le signal de commande, dans au moins un état de fonctionnement de l'unité de commande (30), au moins initie une incrémentation répétée ou une décrémentation répétée d'une grandeur de réglage, dans laquelle l'unité de commande (30) est ménagée pour définir un incrément absolu (ΔS1, ΔS2, ΔS3) de l'incrémentation répétée ou de la décrémentation répétée de la grandeur de réglage en fonction d'un montant absolu de la grandeur caractéristique de mouvement déterminée par l'unité de commande (30), **caractérisée en ce que** le champ de détection (42) présente une étendue linéaire maximale (64 ; 78) de maximum 70 millimètres entre des parties tactiles du champ de détection (42) pour détecter la position de contact, et dans laquelle l'unité de commande (30) est ménagée pour modifier l'incrément absolu (ΔS1, ΔS2, ΔS3) lors d'une approche vers au moins une valeur limite prédéterminée de la grandeur de réglage en fonction d'un écart d'une valeur momentanée de la grandeur de réglage par rapport à la valeur limite prédéterminée de la grandeur de réglage.

2. Table de cuisson selon la revendication 1, **caractérisée en ce que** les au maximum quatre éléments capteurs (60, 62 ; 68, 70, 72 ; 76) sont disposés à distance les uns des autres dans la direction (18) de la grandeur caractéristique de mouvement.

3. Table de cuisson au moins selon la revendication 1, **caractérisée en ce que** l'unité de commande (30) est ménagée, dans le but de déterminer la grandeur caractéristique de mouvement, pour utiliser au moins une durée entre une activation d'un premier élément capteur tactile (60, 62 ; 68, 70, 72 ; 76) et une activation au moins d'un deuxième élément capteur tactile (60, 62 ; 68, 70, 72 ; 76) du champ de détection (42).

4. Table de cuisson au moins selon la revendication 1, **caractérisée en ce que** la grandeur de réglage, dans au moins un mode de fonctionnement, est un temps de présélection d'une fonction de minuterie.

5. Table de cuisson au moins selon la revendication 4, **caractérisée en ce que** l'unité de commande (30) est ménagée pour fournir un signal de commande lors de déterminations de grandeurs caractéristiques de mouvement se succédant pendant un intervalle de temps prédéterminé, dont la grandeur absolue est située dans une plage prédéterminée, lequel signal de commande au moins initie de manière prédéfinie une augmentation d'un incrément absolu (ΔS1, ΔS2, ΔS3) pour une incrémentation ou une décrémentation de la grandeur de réglage.

6. Table de cuisson au moins selon la revendication 1, **caractérisée en ce que** l'unité de commande (30) est ménagée, dans au moins un mode de fonctionnement, pour déterminer une grandeur caractéristique de mouvement à partir d'une séquence temporelle de positions de contact détectées par un seul élément capteur (60, 62 ; 68, 70, 72 ; 76) sur le champ de détection (42).

7. Table de cuisson selon l'une quelconque des revendications précédentes, **caractérisée en ce que** l'unité de commande (30) comprend une unité de réglage d'incrément (34) et est ménagée pour fournir un signal de commande lors d'une activation de l'unité de réglage d'incrément (34), lequel au moins initie une incrémentation ou une décrémentation d'un incrément absolu prédéterminé (ΔS1, ΔS2, ΔS3).
